# EUROPÄISCHE PATENTSCHRIFT

(11) **EP 4 042 846 B1**
(45) Veröffentlichungstag und Bekanntmachung des Hinweises auf die Patenterteilung: **16.08.2023**
(21) Anmeldenummer: 20771197.9
(22) Anmeldetag: 28.08.2020
(51) Int. Cl.: H05K 7/14, H05K 7/20

(54) **SCHALTSCHRANK MIT EINEM IN EINE OFFENSTELLUNG VORGESPANNTEN SCHLIESSELEMENT**
SWITCH CABINET HAVING A CLOSING ELEMENT PRELOADED INTO AN OPEN POSITION
ARMOIRE DE DISTRIBUTION COMPRENANT UN ÉLÉMENT DE FERMETURE PRÉCONTRAINT DANS UNE POSITION D'OUVERTURE

(30) Priorität: 11.10.2019 DE 102019127470
(43) Veröffentlichungstag der Anmeldung: 17.08.2022
(73) Patentinhaber: Rittal GmbH & Co. KG, 35745 Herborn (DE)
(72) Erfinder: LAURÖSCH, Sven Michael, 35708 Haiger (DE); PHILIPP, Frank, 56470 Bad Marienberg (DE); BÄUMER, Carsten, 57258 Freudenberg (DE)
(74) Vertreter: Angerhausen, Christoph
(86) Internationale Anmeldenummer: PCT/DE2020/100763
(87) Internationale Veröffentlichungsnummer: WO 2021/069011

(56) Entgegenhaltungen:
- CN-A- 109 119 914
- CN-B- 105 491 836
- CN-U- 205 336 686
- DE-B3-102006 010 360
- JP-A- 2012 234 364
- KR-A- 20190 076 402
- KR-B1- 101 468 874
- US-A1- 2004 100 770

## Beschreibung

Die Erfindung geht aus von einem Schaltschrank mit einem Gehäuse und einer daran über mindestens ein Scharnier verschwenkbar festgelegten, ein Türblatt aufweisenden Tür, die entgegen einer mechanischen Vorspannung in Richtung ihrer Offenstellung von einem elektrisch ansteuerbaren Zuhalteelement in einer Schließstellung gehalten ist, wobei das Türblatt einen Durchbruch und ein den Durchbruch verschließendes Schließelement aufweist, das entgegen seiner mechanischen Vorspannung in Richtung seiner Offenstellung von einem elektrisch ansteuerbaren Zuhalteelement in einer Schließstellung gehalten ist. Ein derartiger Schaltschrank ist aus der EP 2 693 514 A1 bekannt. Ähnliche Schaltschränke beschreiben auch die JP 2012 234364 A, die CN 105491836 B und die DE 10 2006 010 360 B3.

Gattungsgemäße Schaltschränke sind insbesondere dazu eingerichtet, um in einem Havariefall, beispielsweise bei einem Ausfall der Kühlung der in dem Schaltschrankgehäuse aufgenommenen elektrischen Schaltanlage, IT-Umgebung oder dergleichen, eine Notbelüftung des Schaltschrankinnenraums zu ermöglichen, um beispielsweise einen Serverausfall zumindest hinauszuzögern, so dass Zeit gewonnen wird, um Maßnahmen einzuleiten, die entweder den normalen Betriebszustand der Schaltschrankanlage wieder herstellen, oder um die Schaltanlage bzw. insbesondere eine IT-Umgebung ordnungsgemäß herunterzufahren, so dass eine Zerstörung des Systems vermieden wird.

Um die Schaltschranktür in die Offenstellung mechanisch vorzuspannen, werden geeignete Vorspannmittel verwendet, beispielsweise Gasdruckfedern. Dies hat den Nachteil, dass nach einer regulären Öffnung der Schaltschranktür, beispielsweise um eine Wartung der im Schaltschrank aufgenommenen Anlage bzw. IT-Umgebung durchzuführen, beim Wiederverschließen des Schaltschranks von einem Anwender eine erhebliche Kraft aufgewendet werden muss, um die Vorspannung des Schließelements zu überwinden. Darüber hinaus bedingen die Prinzipien des Systems, dass keine standardisierten Verschlusssysteme des Schaltschranks verwendet werden können, beispielsweise Schubstangenverschlüsse, was dem Bestreben nach Gleichteileverwendung entgegenwirkt. Darüber hinaus haben die bekannten Schaltschränke den Nachteil, dass beispielsweise im Notfall vollautomatisch durch elektrisches Ansteuern des Zuhalteelements geöffnete Türen einen ungehinderten Zugriff auf den Schaltschrankinnenraum ermöglichen, was nicht nur aus Gründen des Datenschutzes unerwünscht sein kann.

Es ist daher die Aufgabe der Erfindung, einen Schaltschrank der eingangs beschriebenen Art derart weiterzuentwickeln, dass er die Aufwendung hoher Schließkräfte beim Verschließen der Schaltschranktür vermeidet, darüber hinaus auf die Verwendung besonderer Verschlüsse für die Schaltschranktür verzichtet und im Übrigen dazu vorbereitet ist, im Bedarfsfall einen Zugriffschutz auf den Innenraum des Schaltschranks zu gewährleisten, wenn der Schaltschrank in einem notgeöffneten Zustand ist.

Diese Aufgabe wird durch einen Schaltschrank mit den Merkmalen des Anspruchs 1 gelöst. Die abhängigen Ansprüche betreffen jeweils vorteilhafte Ausführungsformen der Erfindung.

Demgemäß ist vorgesehen, dass das Türblatt einen Durchbruch und ein den Durchbruch verschließendes Schließelement aufweist, das entgegen seiner mechanischen Vorspannung in Richtung seiner Offenstellung von einem elektrisch ansteuerbaren Zuhalteelement in einer Schließstellung gehalten ist.

Dadurch, dass nicht die gesamte Schaltschranktür für die Notbelüftung des Schaltschrankgehäuses geöffnet werden muss, wird zum einen erreicht, dass im Regelbetrieb der Schaltschrankanlage von einem Anwender, wie er es bei Schaltschränken ohne Notbelüftung gewohnt ist, die Schaltschranktür ohne die Aufwendung einer hohen Schließkraft geöffnet und geschlossen werden kann, da er nicht mehr gegen die Vorspannkraft der Notöffnung arbeiten muss. Darüber hinaus kann auch das Schließsystem der Schaltschranktür wie bei einem standardmäßigen Schaltschrank ohne Notbelüftung ausgebildet sein, beispielsweise als ein Schubstangenverschluss, der über einen Kniehebel-Türgriff verstellbar ist. Schließlich erlaubt es die erfindungsgemäße Lösung, dass an der Innenseite des Türblatts geeignete Maßnahmen vorgesehen sind, um einen Zugriff auf den Schaltschrankinnenraum zu unterbinden, wenn sich das Schließelement bei geschlossener Schaltschranktür in einer Offenstellung befindet. Dazu kann beispielsweise ein Zugriffsschutzgitter, beispielsweise ein Lochgitter, vorgesehen sein, welches den Durchbruch von der Innenseite des Türblatts verschließt. Im Regelbetrieb, bei welchem der Anwender beispielsweise im Wartungsfall die Schaltschranktür öffnet, hindert der Zugriffsschutz den Anwender nicht daran, Zugriff auf den Schaltschrankinnenraum zu erlangen. Eine Zugangsberichtigungsabfrage kann wie bei Standardschaltschränken über den Türgriff der Schaltschranktür erfolgen, etwa über ein Zylinderschloss oder eine Drahtlosschnittstelle zur Auslesung einer Zugangsberechtigungskarte.

Die Vorspannung in Richtung der Offenstellung kann von mindestens einer sich in dem Durchbruch erstreckenden Druckfeder, vorzugsweise von einer Gasdruckfeder bereitgestellt sein.

Das Schließelement kann eine Tür sein, die mindestens einen Türflügel, vorzugsweise zwei Türflügel aufweist, der/die an einer vertikalen Berandung des Durchbruchs über mindestens ein weiteres Scharnier verschwenkbar festgelegt ist/sind. Demgemäß kann die erfindungsgemäße Schaltschranktür bei einer Ausführungsform als ein Tür-in-Tür-Konzept ausgelegt sein. Es kann vorgesehen sein, dass sich der Durchbruch über einen Großteil der Höhe und der Breite des Türblatts erstreckt, um einen möglichst großen Öffnungsquerschnitt für den Austausch von Luft bereitzustellen. Vorzugsweise erstreckt sich der Durchbruch über mindestens 50 % der Höhe und/oder der Breite des Türblatts.

Es kann vorgesehen sein, dass sich der Durchbruch einteilig über einen Großteil der Höhe des Türblatts erstreckt, mindestens jedoch über 50 % der Höhe. Weiterhin kann vorgesehen sein, dass der Durchbruch in Breitenrichtung über einen vertikalen Mittelsteg des Türblatts zweigeteilt ist, während er in Höhenrichtung vorzugsweise unterbrechungsfrei ausgebildet ist.

Das elektrisch ansteuerbare Zuhalteelement kann mindestens einen Elektromagneten aufweisen, der an einer Innenseite des Türblatts über eine Berandung des Durchbruchs in die lichte Öffnung des Durchbruchs hineinragt.

Die Vorspannung in Richtung der Offenstellung ist zumindest in einem ersten Teilbewegungsabschnitt des Schließelements aus der Schließstellung in Richtung der Offenstellung von einer redundanten Vorspanneinrichtung mit mindestens zwei unabhängig voneinander ausgebildeten Vorspannelementen bereitgestellt.

Dabei kann ein erstes der Vorspannelemente eine Druckfeder, vorzugsweise eine Gasdruckfeder, und ein zweites der Vorspannelemente ein elastisch verformbares Federelement, vorzugsweise eine Schraubenfeder, aufweisen.

Eines der beiden redundanten Vorspannelemente soll erfindungsgemäß mit dem Schließelement außer Eingriff stehen und das andere weiterhin mit dem Schließelement in Eingriff stehen, wenn das Schließelement außerhalb des ersten Bewegungsabschnitts in einer teilgeöffneten Stellung zwischen der Offenstellung und der Schließstellung angeordnet ist. Auf diese Weise ist es möglich, dass bei der Auslösung, mithin der Freigabe des elektrisch ansteuerbaren Zuhalteelements entlang des ersten Teilbewegungsabschnitts des Schließelements aus der Schließstellung ein erhöhtes Drehmoment auf das Schließelement ausgeübt wird, um ein schnelles Herausbewegen des Schließelements aus der Schließstellung zu erreichen.

Der Durchbruch kann an einer dem Innern des Schaltschranks zugewandten Innenseite des Türblatts von einem luftdurchlässigen Zugriffsschutzgitter überdeckt sein. Dabei kann das mindestens eine den Durchbruch verschließende Schließelement mindestens einen Türflügel aufweisen, der aus der Schließstellung zur Außenseite des Türblatts in Richtung Offenstellung verschwenkbar ist.

Die Tür des Schaltschranks kann vorspannungsfrei zwischen einer vollständig geöffneten Stellung und einer vollständig geschlossenen Stellung, in der das Türblatt über ein Dichtelement am Rahmengestell des Schaltschranks anliegt, hin und her bewegbar und in der Schließstellung unter Komprimierung des Dichtelements mit einem Schubstangenverschluss an dem Rahmengestell arretiert sein, so dass sich im Regelbetrieb, d. h. in einer Betriebssituation, in welcher eine Notbelüftung des Schaltschranks nicht ausgelöst wurde, für einen Anwender kein Bedienungsunterschied zu einem Standardschaltschrank, welcher keine Notbelüftung aufweist, existiert.

Die Tür des Schaltschranks kann zwei gegenläufige und an gegenüber liegenden vertikalen Profilseiten des Gehäuses anscharnierte Teiltüren aufweisen, von denen jede einen das Schließelement bildenden Türflügel aufweist, der an einer äußeren der beiden vertikalen Berandung des Durchbruchs über mindestens ein weiteres Scharnier verschwenkbar festgelegt ist.

Alternativ kann die Tür des Schaltschranks eine an einer vertikalen Profilseite des Gehäuses anscharnierte Tür mit zwei das Schließelement bildenden Türflügeln sein, wobei die Türflügel gleichläufig verschwenkbar sind, wozu ein erster der Türflügel an einer äußeren von zwei vertikalen Berandungen des Durchbruchs über mindestens ein weiteres Scharnier verschwenkbar festgelegt ist und ein zweiter der Türflügel an einem den Durchbruch zweiteilenden vertikalen Mittelsteg des Türblatts über mindestens ein weiteres Scharnier verschwenkbar festgelegt ist.

Weitere Einzelheiten der Erfindung werden anhand der nachstehenden Figuren erläutert. Dabei zeigt:
- Figur 1: einen gattungsgemäßen Schaltschrank gemäß dem Stand der Technik;
- Figur 2: eine Vorderansicht einer beispielhaften Ausführungsform einer erfindungsgemäßen Schaltschranktür;
- Figur 3: in perspektivischer Darstellung die Schaltschranktür gemäß Figur 2 mit geöffneten Schließelement;
- Figur 4: eine Detailansicht eines Horizontalquerschnitts durch eine weitere Ausführungsform eines erfindungsgemäßen Schaltschranks;
- Figur 5: die Ausführungsform gemäß Figur 4 in einem teilgeöffneten Zustand des Schließelements; und
- Figur 6: eine Detailansicht einer weiteren Ausführungsform einer erfindungsgemäßen Schaltschranktür mit geöffnetem Schließelement.

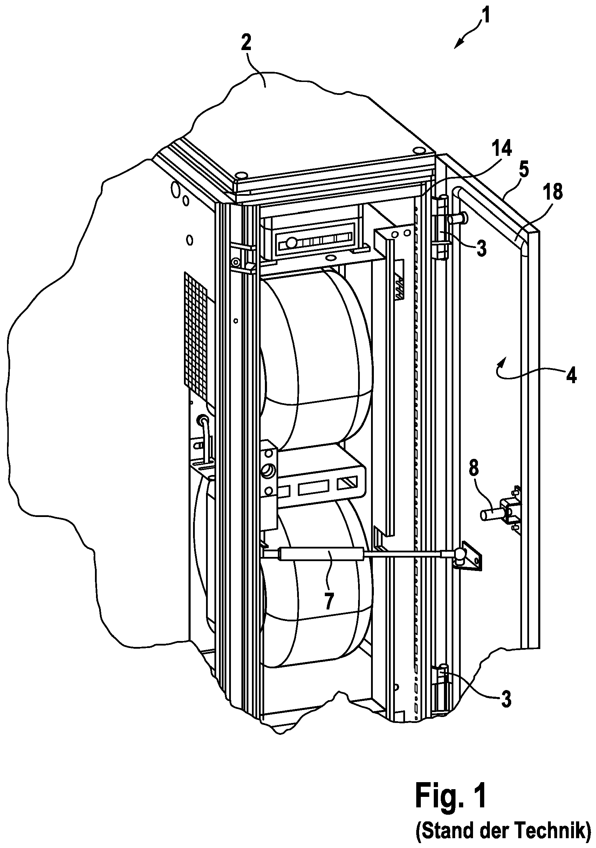

Die Figur 1 zeigt einen Ausschnitt eines Schaltschranks 1, wie er aus dem Stand der Technik bekannt und in allen Einzelheiten in der DE 10 2016 010 360 B3 beschrieben ist.

Der Schaltschrank 1 weist ein Rahmengestell 14 auf, an dem diverse Flachteile festgelegt sind, beispielsweise eine Seitenwand, ein Dachblech und insbesondere die sich in der Ausführungsform gemäß Figur 1 in einem geöffneten Zustand befindende Rücktür 5, welche an einer Rückseite des Schaltschranks 1 bereitgestellt ist und für eine Notöffnung im Havariefall ausgelegt ist, um beispielsweise bei einer ausfallenden Schaltschrankkühlung eine Notbelüftung des Schaltschrankinnenraums bereitzustellen.

Für die Notbelüftung ist die Schaltschranktür 5 mit einem als eine Gasdruckfeder ausgebildeten Schließelement 7 in seine in Figur 1 gezeigte Offenstellung vorgespannt, während ein beispielsweise als Magnetschloss ausgebildetes Zuhalteelement 8 dazu eingerichtet ist, im Regelbetrieb der Schaltschrankanlage, d. h. in jedem Fall, wo die in Figur 1 dargestellte Notbelüftung des Schaltschrankinnenraums nicht erforderlich ist, die Rückwandtür 5 in einem geschlossenen Zustand zu halten, wozu das Zuhalteelement 8 eine Schließkraft bereitstellen muss, welcher der von der Gasdruckfeder 7 bereitgestellten Vorspannung in die Offenstellung entgegenwirkt, d. h. diese zumindest kompensiert und vorzugsweise deutlich überkompensiert.

Die Ausführungsform gemäß Figur 1 veranschaulicht, dass beispielsweise im Wartungsfall ein Anwender, nachdem er die Rückwandtür 5 geöffnet hat, nicht nur durch die Gasdruckfeder 7 gehindert ist, störungsfreien Zugriff auf den Innenraum zu erlangen. Vielmehr muss er nach erfolgter Wartung für das Wiederverschließen der Rückwandtür 5 die Vorspannkraft der Gasdruckfeder überwinden, um die Tür 5 in ihre Schließstellung zu überführen. Nachdem er unter entsprechendem Kraftaufwand die Tür 5 in die Schließstellung gebracht hat, muss er das Zuhaltelement 8 aktivieren, beispielsweise ein Magnetschloss, so dass die Tür 5 entgegen der Vorspannung der Gasdruckfeder 7 in der geschlossenen Stellung gehalten ist. Darüber hinaus zeigt die Figur 1, dass in dem Fall, dass das Zuhalteelement 8 ausgelöst und daraufhin die Tür 5 geöffnet wurde, jeder gegebenenfalls unbefugte Dritte Zugriff auf den Innenraum des Schaltschranks 1 hat.

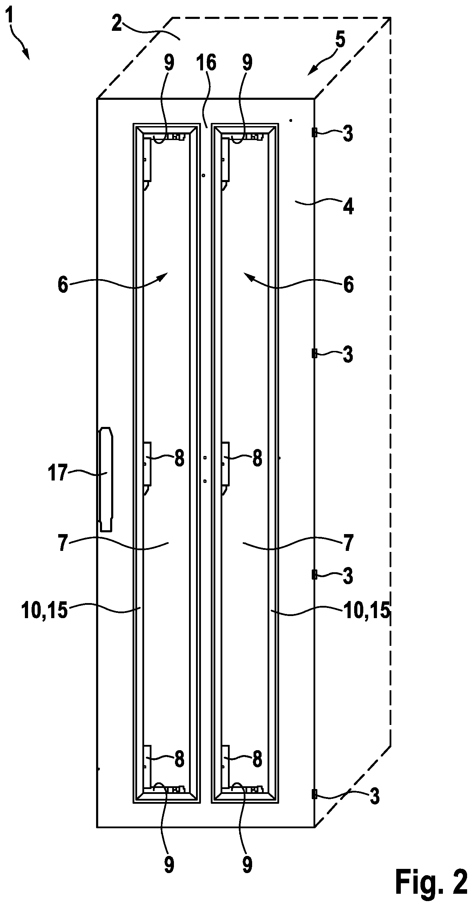

Demgegenüber veranschaulicht die Figur 2 eine beispielhafte Ausführungsform einer erfindungsgemäßen Schaltschranktür 5, die ein Türblatt 4 aufweist, welches an gegenüberliegenden Vertikalseiten eine Reihe äquidistanter Scharniere 3 bzw. türseitiger Scharnierhälften und andererseits auf der gegenüberliegenden Vertikalseite einen Schubstangenverschluss 17 aufweist, der über einen an der Vorderseite des Türblatts 4 montierten Kniehebel verstellt werden kann. Insoweit ist die Schaltschranktür 5 wie eine Standardschaltschranktür ausgebildet, welche nicht für eine Notbelüftung vorbereitet ist, so dass auch insoweit die Verwendung von Gleichteilen möglich ist.

Erfindungsgemäß weist die Schaltschranktür 5 einen Durchbruch 6 auf, der vorliegend über einen Vertikalsteg 16 zweigeteilt ausgebildet ist und sich im Wesentlichen über die gesamte oder annähernd über die gesamte Höhe des Türblatts 4 erstreckt. In der zur Höhe senkrechten Breitenrichtung der Tür 5 weist der Durchbruch 6 eine Breite auf, die zumindest mehr als 50 % der Breite des Türblatts 4 entspricht. Das Schließelement 7 weist demgemäß zwei Türflügel 10 auf, die jeweils als einseitig anscharnierte Teiltüren 15 ausgebildet sind.

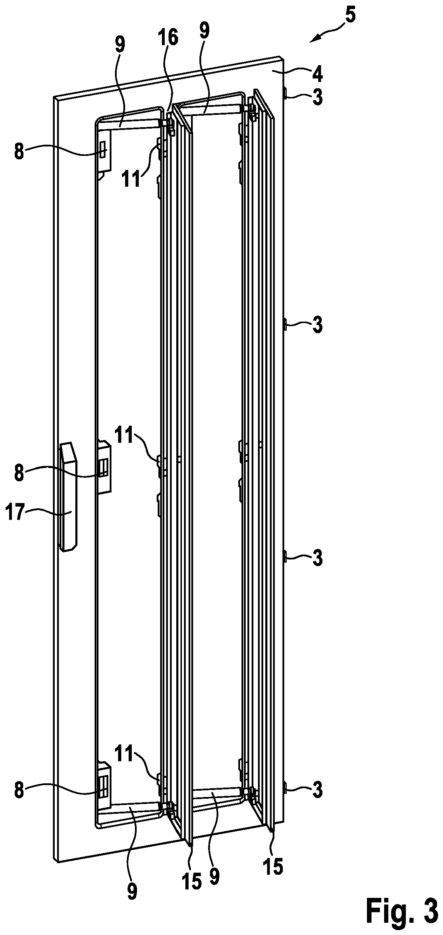

Die Teiltüren 15 sind an ihrer der Scharnierseite gegenüberliegenden Vertikalseite mit Hilfe von jeweils drei vertikal und äquidistant untereinander angeordneten Zuhalteelementen 8, die beispielsweise Magnetschlösser sein können, in der in Figur 2 gezeigten Schließstellung gehalten. An einer Unterseite und an einer Oberseite der Teiltüren 15 ist je Teiltür 15 jeweils eine Gasdruckfeder 9 vorgesehen, welche sich in der in Figur 2 gezeigten Stellung der Tür in einer komprimierten Stellung befinden und demgemäß eine Vorspannung auf die Teiltüren 15 in Richtung der in Figur 3 gezeigten Offenstellung ausüben. Die Zuhalteelemente 8 überwinden diese Vorspannung und halten die Teiltüren 15 in der in Figur 2 gezeigten geschlossenen Stellposition.

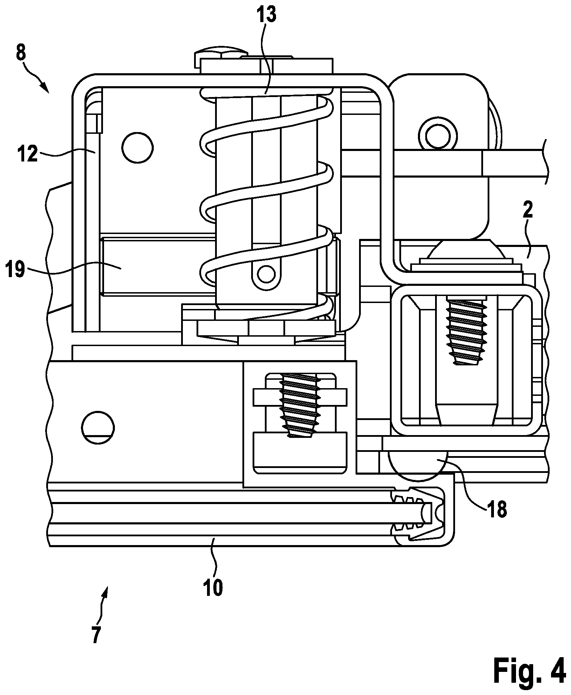

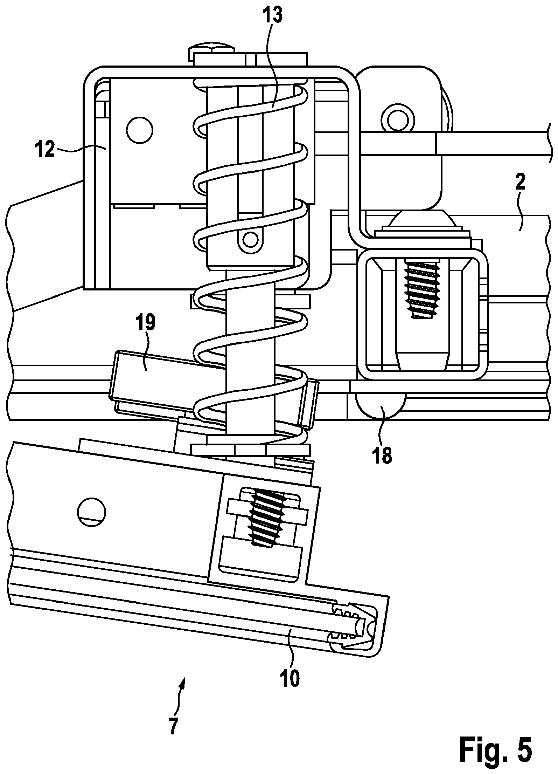

Die Zuhalteelemente 8 sind elektrisch ansteuerbar und können beispielsweise als Magnetschlösser ausgebildet sein, welche, wie dies in den Figuren 4 und 5 gezeigt ist, einen Elektromagneten 12 aufweisen können, der an dem Türblatt 4 der Schaltschranktür 5 derart befestigt ist, dass er in den Durchbruch 6 hineinragt. Im Gegenzug weist der Türflügel 10 des Schließelements 7 eine magnetische oder magnetisierbare Ankerplatte auf, so dass der Türflügel 10 über eine von dem Elektromagneten 12 bereitgestellte elektrische Anziehungskraft in der in Figur 4 gezeigten geschlossenen Stellung gehalten werden kann. Im Falle der Notbelüftung kann der Elektromagnet stromlos geschaltet werden, so dass die magnetische Anziehungskraft zwischen dem Elektromagneten 12 und der Ankerplatte 19 unterbrochen wird, woraufhin der Türflügel 10 aufgrund der auf ihn ausgeübten Vorspannung in seine Offenstellung verschwenkt wird, wie dies in Figur 5 gezeigt ist.

Um bei dem Übergang des Türflügels 10 von der in Figur 4 gezeigten Schließstellung in die in Figur 5 gezeigte teilweise geöffnete Stellung des Türflügels 10 ein möglichst hohes Drehmoment auf den Türflügel 10 auszuüben, wodurch der Türflügel 10 die in Figur 5 gezeigte teilgeöffnete Stellung schnell erreicht, ist vorgesehen, dass neben einer beispielsweise für die vollständige Öffnung erforderlichen Gasdruckfeder eine zusätzliche Vorspannkraft mit Hilfe einer elastischen Druckfeder 13 bereitgestellt wird, die bei der vorliegenden Ausführungsform als eine Schraubenfeder ausgebildet ist. Die Schraubenfeder hat darüber hinaus die Funktion, dass beim Wiederverschließen des Türflügels bei bereits aktiviertem Elektromagnet eine Dämpfung der von der magnetischen Anziehungskraft erzeugten Schließbewegung des Türflügels 10 erreicht wird, wodurch beispielsweise die Klemmgefahr vermindert wird.

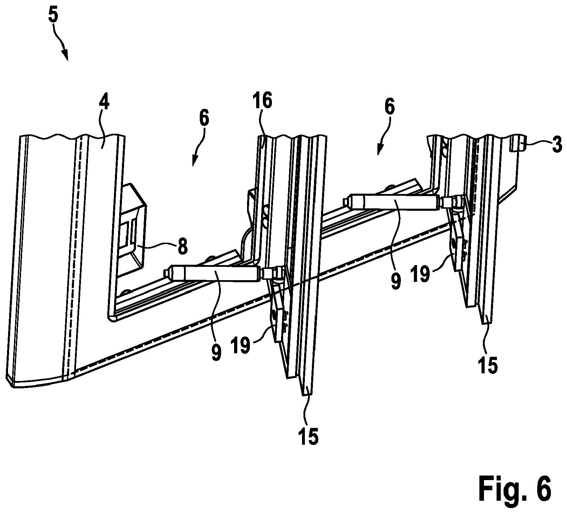

Eine weitere Ausführungsform einer erfindungsgemäßen Schaltschranktür 5 ist in Figur 6 gezeigt. Bei dieser ist wiederum der Durchbruch 6 zweiteilig ausgeführt und über einen sich in Vertikalrichtung über die gesamte Höhe des Durchbruchs 6 erstreckenden Mittelsteg 16 in zwei gleich große Teildurchbrüche unterteilt. Jeder der Teildurchbrüche ist von einer separaten Teiltür 15 verschließbar und im Bedarfsfall mit Hilfe der Druckfeder 9 öffenbar, wenn eine von den Elektromagneten 12 auf die Ankerplatten 19 wirkende magnetische Anziehungskraft unterbrochen wird.

Die in der vorstehenden Beschreibung, in der Zeichnung sowie in den Ansprüchen offenbarten Merkmale der Erfindung können sowohl einzeln als auch in beliebiger Kombination für die Erfindung wesentlich sein.

### Bezugszeichenliste

- 1: Schaltschrank
- 2: Gehäuse
- 3: Scharnier
- 4: Türblatt
- 5: Tür
- 6: Durchbruch
- 7: Schließelement
- 8: Zuhalteelement
- 9: Druckfeder
- 10: Türflügel
- 11: weiteres Scharnier
- 12: Elektromagnet
- 13: Federelement
- 14: Rahmengestell
- 15: Teiltür
- 16: Mittelsteg
- 17: Schubstangenverschluss
- 18: Dichtelement
- 19: Ankerplatte

## Patentansprüche

1. Schaltschrank (1) mit einem Gehäuse (2) und einer daran über mindestens ein Scharnier (3) verschwenkbar festgelegten, ein Türblatt (4) aufweisenden Tür (5), wobei das Türblatt (4) einen Durchbruch (6) und ein den Durchbruch (6) verschließendes Schließelement (7) aufweist, das entgegen seiner mechanischen Vorspannung in Richtung seiner Offenstellung von einem elektrisch ansteuerbaren Zuhalteelement (8) in einer Schließstellung gehalten ist, **dadurch gekennzeichnet, dass** die Vorspannung in Richtung der Offenstellung in einem ersten Teilbewegungsabschnitt des Schließelements (7) aus der Schließstellung in Richtung der Offenstellung von einer redundanten Vorspanneinrichtung mit mindestens zwei unabhängig voneinander ausgebildeten Vorspannelementen (9, 13) bereitgestellt ist, und wobei eines der beiden redundanten Vorspannelemente (9, 13) mit dem Schließelement (7) außer Eingriff steht und das andere weiterhin mit dem Schließelement (7) in Eingriff steht, wenn das Schließelement (7) außerhalb des ersten Teilbewegungsabschnitts in einer teilgeöffneten Stellung zwischen der Offenstellung und der Schließstellung angeordnet ist.

2. Schaltschrank (1) nach Anspruch 1, bei dem die Vorspannung in Richtung der Offenstellung von mindestens einer sich in dem Durchbruch (6) erstreckenden Druckfeder (9), vorzugsweise von einer Gasdruckfeder bereitgestellt ist.

3. Schaltschrank (1) nach Anspruch 1 oder 2, bei dem das Schließelement (7) eine Tür ist, die mindestens einen Türflügel (10), vorzugsweise zwei Türflügel (10) aufweist, der an einer vertikalen Berandung des Durchbruchs (6) über mindestens ein weiteres Scharnier (11) verschwenkbar festgelegt ist.

4. Schaltschrank (1) nach einem der vorangegangenen Ansprüche, bei dem das elektrisch ansteuerbare Zuhalteelement (8) mindestens einen Elektromagneten (12) aufweist, der an einer Innenseite des Türblatts (4) über eine Berandung des Durchbruchs (6) in die lichte Öffnung des Durchbruchs (6) hineinragt.

5. Schaltschrank (1) nach Anspruch 1, bei dem ein erstes der Vorspannelemente eine Druckfeder (9), vorzugsweise eine Gasdruckfeder, und ein zweites der Vorspannelemente ein elastisch verformbares Federelement (13), vorzugsweise eine Schraubenfeder, aufweist.

6. Schaltschrank (1) nach einem der vorangegangenen Ansprüche, bei dem der Durchbruch (6) an einer dem Innern des Schaltschranks (1) zugewandten Innenseite des Türblatts (4) von einem luftdurchlässigen Zugriffsschutzgitter überdeckt ist, wobei das mindestens eine den Durchbruch (6) verschließende Schließelement (7) mindestens einen Türflügel (10) aufweist, der aus der Schließstellung zur Außenseite des Türblatts (4) in Richtung Offenstellung verschwenkbar ist.

7. Schaltschrank (1) nach einem der vorangegangenen Ansprüche, bei dem die Tür (5) des Schaltschranks (1) vorspannungsfrei zwischen einer vollständig geöffneten Stellung und einer vollständig geschlossenen Stellung, in der das Türblatt (4) über ein Dichtelement (18) am Rahmengestell (14) des Schaltschranks (1) anliegt, hin und her bewegbar und in der Schließstellung unter Komprimierung des Dichtelements (18) mit einem Schubstangenverschluss (17) an dem Rahmengestell (14) arretiert ist.

8. Schaltschrank (1) nach einem der vorangegangenen Ansprüche, bei dem die Tür (5) des Schaltschranks (1) entweder
a. zwei gegenläufige und an gegenüberliegenden vertikalen Profilseiten des Gehäuses (2) anscharnierte Teiltüren (15) aufweist, von denen jede einen das Schließelement (7) bildenden Türflügel (10) aufweist, der an einer äußeren der beiden vertikalen Berandung des Durchbruchs (6) über mindestens ein weiteres Scharnier (11) verschwenkbar festgelegt ist; oder
b. eine an einer vertikalen Profilseite des Gehäuses (2) anscharnierte Tür (5) mit zwei das Schließelement (7) bildenden Türflügeln (10) ist, wobei die Türflügel (10) gleichläufig verschwenkbar sind, wozu ein erster der Türflügel (10) an einer äußeren von zwei vertikalen Berandungen des Durchbruchs (6) über mindestens ein weiteres Scharnier (11) verschwenkbar festgelegt ist und ein zweiter der Türflügel (10) an einem den Durchbruch (6) zweiteilenden vertikalen Mittelsteg (16) des Türblatts (4) über mindestens ein weiteres Scharnier (11) verschwenkbar festgelegt ist.

9. Schaltschrank (1) nach einem der vorangegangenen Ansprüche, bei dem sich der Durchbruch (6) über einen Großteil der Höhe und der Breite des Türblatts (4) erstreckt, mindestens jedoch über mehr 50% der Höhe und der Breite.

10. Schaltschrank (1) nach einem der vorangegangenen Ansprüche, bei dem sich der Durchbruch (6) einteilig über einen Großteil der Höhe des Türblatts (4) erstreckt, mindestens jedoch über mehr 50% der Höhe.

11. Schaltschrank (1) nach einem der vorangegangenen Ansprüche, bei dem der Durchbruch (6) in Breitenrichtung über einen vertikalen Mittelsteg (16) des Türblatts (4) zweigeteilt ist, während er in Höhenrichtung unterbrechungsfrei ist.

## Claims

1. A switch cabinet (1) having a housing (2) and a door (5) which is pivotably secured thereto via at least one hinge (3), the door (5) having a door leaf (4), wherein the door leaf (4) has an aperture (6) and a closing element (7) which closes the aperture (6) and is held in a closed position, counter to its mechanical pretension in the direction of its open position, by an electrically controllable locking element (8), **characterized in that** the pretension in the direction of the open position is provided, at least in a first partial movement section of the closing element (7) from the closed position in the direction of the open position, by a redundant pretensioning device having at least two pretensioning elements (9, 13) which are designed independently of one another, and wherein one of the two redundant pretensioning elements (9, 13) is disengaged from the closing element (7) and the other continues to be engaged with the closing element (7) when the closing element (7) is disposed outside the first partial movement section in a partially open position between the open position and the closed position.

2. The switch cabinet (1) according to claim 1, wherein the pretension in the direction of the open position is provided by at least one compression spring (9) extending in the aperture (6), preferably by a gas compression spring.

3. The switch cabinet (1) according to claim 1 or 2, in which the closing element (7) is a door which has at least one door leaf (10), preferably two door leaves (10), which is pivotably fixed to a vertical edge of the aperture (6) via at least one further hinge (11).

4. The switch cabinet (1) according to any one of the preceding claims, in which the electrically controllable locking element (8) has at least one electromagnet (12) which projects into the clear opening of the aperture (6) on an inner side of the door leaf (4) beyond a border of the aperture (6).

5. The switch cabinet (1) according to claim 1, wherein a first of said pretensioning elements comprises a compression spring (9), preferably a gas compression spring, and a second of said pretensioning elements comprises an elastically deformable spring element (13), preferably a coil spring.

6. The switch cabinet (1) according to one of the preceding claims, in which the aperture (6) is covered by an air-permeable access protection grille on an inner side of the door leaf (4) facing the interior of the switch cabinet (1), the at least one closing element (7) closing the aperture (6) having at least one door leaf (10) which can be pivoted from the closed position towards the outer side of the door leaf (4) in the direction of the open position.

7. The switch cabinet (1) according to one of the preceding claims, in which the door (5) of the switch cabinet (1) can be moved back and forth without pretension between a fully open position and a fully closed position, in which the door leaf (4) bears against the frame (14) of the switch cabinet (1) via a sealing element (18), and in the closed position is locked to the frame (14) with compression of the sealing element (18) by a push rod lock (17).

8. The switch cabinet (1) according to any one of the preceding claims, wherein the door (5) of the switch cabinet (1) either
a. has two part doors (15) which move in opposite directions and are hinged to opposite vertical profile sides of the housing (2), each of which has a door leaf (10) which forms the closing element (7) and is fixed pivotably to an outer one of the two vertical edges of the opening (6) via at least one further hinge (11); or
b. is a door (5) hinged to a vertical profile side of the housing (2) and having two door leaves (10) forming the closing element (7), the door leaves (10) being pivotable in the same direction, for which purpose a first one of the door leaves (10) is pivotably secured to an outer one of two vertical edges of the opening (6) via at least one further hinge (11), and a second one of the door leaves (10) is pivotably secured to a vertical central web (16) of the door leaf (4), which vertical web bisects the opening (6), via at least one further hinge (11).

9. The switch cabinet (1) according to any one of the preceding claims, wherein the aperture (6) extends over a major part of the height and the width of the door leaf (4), but at least over more than 50% of the height and the width.

10. The switch cabinet (1) according to any one of the preceding claims, wherein the aperture (6) extends integrally over a major part of the height of the door leaf (4), but at least over more than 50% of the height.

11. The switch cabinet (1) according to any one of the preceding claims, in which the aperture (6) is divided in two in the width direction via a vertical central web (16) of the door leaf (4), while it is uninterrupted in the height direction.

## Revendications

1. Armoire de commande (1) avec un boîtier (2) et une porte (5), fixée à celui-ci de manière pivotante par l'intermédiaire d'au moins une charnière (3), comprenant un vantail de porte (4), dans lequel le battant de porte (4) comprend une percée (6) et un élément de fermeture (7) fermant la percée (6), qui est maintenu dans une position de fermeture contre sa précontrainte mécanique en direction de sa position d'ouverture par un élément de retenue (8) pouvant être contrôlé électriquement, **caractérisée en ce que** la précontrainte en direction de la position d'ouverture est produite, dans une première portion de mouvement partiel de l'élément de fermeture (7) de la position de fermeture en direction de la position d'ouverture, par un dispositif de précontrainte redondant avec au moins deux éléments de précontrainte (9, 13) réalisés indépendamment entre eux et dans lequel un des deux éléments de précontrainte redondants (9, 13) est déboîté de l'élément de fermeture (7) et l'autre est toujours emboîté avec l'élément de fermeture (7) lorsque l'élément de fermeture (7) est disposé à l'extérieur de la première portion de mouvement partiel dans une position partiellement ouverte entre la position d'ouverture et la position de fermeture.

2. Armoire de commande (1) selon la revendication 1, dans laquelle la précontrainte en direction de la position d'ouverture est produite par au moins un ressort de compression (9), de préférence un ressort à pression de gaz, s'étendant dans la percée (6).

3. Armoire de commande (1) selon la revendication 1 ou 2, dans laquelle l'élément de fermeture (7) est une porte qui comprend au moins un battant de porte (10), de préférence deux battants de porte (10), qui sont fixés de manière pivotante à une bordure verticale de la percée (6) par l'intermédiaire d'au moins une autre charnière (11).

4. Armoire de commande (1) selon l'une des revendications précédentes, dans laquelle l'élément de retenue (8) contrôlable électriquement comprend au moins un électro-aimant (12) qui dépasse, au niveau d'une face interne du vantail de porte (4), d'une bordure de la percée (6) vers l'ouverture de la percée (6).

5. Armoire de commande (1) selon la revendication 1, dans laquelle un premier des éléments de précontrainte comprend un ressort de compression (9), de préférence un ressort à pression de gaz, et un deuxième des éléments de précontrainte comprend un élément de ressort (13) déformable élastiquement, de préférence un ressort hélicoïdal.

6. Armoire de commande (1) selon l'une des revendications précédentes, dans laquelle la percée (6) est recouverte, au niveau d'une face interne du vantail de porte (4), orientée vers l'intérieur de l'armoire de commande (1), par une grille de protection d'accès perméable à l'air, dans laquelle l'au moins un élément de fermeture (7) fermant la percée (6) comprend au moins un battant de porte (10) qui peut être pivoté de la position de fermeture vers la face externe du vantail de porte (4) en direction de la position d'ouverture.

7. Armoire de commande (1) selon l'une des revendications précédentes, dans laquelle la porte (5) de l'armoire de commande (1) est mobile, dans précontrainte, avec un mouvement de va-et-vient entre une position entièrement ouverte et une position entièrement fermée, dans laquelle le vantail de porte (4) s'appuie, par l'intermédiaire d'un élément d'étanchéité (18), contre le châssis (14) de l'armoire de commande (1), et est bloquée, dans la position de fermeture, avec une compression de l'élément d'étanchéité (18) avec une fermeture à crémone (17) contre le châssis (14).

8. Armoire de commande (1) selon l'une des revendications précédentes, dans laquelle la porte (5) de l'armoire de commande (1)
a. soit comprend deux portes partielles (15) inversées et articulées au niveau de faces profilées verticales opposées du boîtier (2), dont chacune comprend un battant de porte (10) formant l'élément de fermeture (7), qui est fixé, de manière pivotante, à une bordure externe des deux bordures verticales de la percée (6), par l'intermédiaire d'au moins une autre charnière (11) ; soit
b. est une porte (5) articulée au niveau d'une face profilée verticale du boîtier (2), avec deux battants de porte (10) formant l'élément de fermeture (7), dans lequel les battants de porte (10) peuvent pivoter dans le même sens, un premier des battants de porte (10) étant pour cela fixé, de manière pivotante, à une bordure externe des deux bordures verticales de la percée (6) par l'intermédiaire d'au moins une autre charnière (11) et un deuxième des battants de porte (10) est fixé, de manière pivotante, à une nervure centrale verticale (16) du vantail de porte (4), divisant la percée (6) en deux, par l'intermédiaire d'au moins une autre charnière (11).

9. Armoire de commande (1) selon l'une des revendications précédentes, dans laquelle la percée (6) s'étend sur une grande partie de la hauteur et de la largeur du vantail de porte (4), cependant au moins sur plus de 50 % de la hauteur et de la largeur.

10. Armoire de commande (1) selon l'une des revendications précédentes, dans laquelle la percée (6) s'étend d'une seule pièce sur une grande partie de la hauteur du vantail de porte (4), cependant au moins sur plus de 50 % de la hauteur.

11. Armoire de commande (1) selon l'une des revendications précédentes, dans laquelle la percée (6) est divisée en deux dans le sens de la largeur par une nervure centrale (16) du vantail de porte (4), alors qu'elle est ininterrompue dans le sens de la hauteur.
